# EUROPEAN PATENT SPECIFICATION

(11) **EP 3 637 474 B1**
(45) Date of publication and mention of the grant of the patent: **05.06.2024**
(21) Application number: 17918868.5
(22) Date of filing: 30.09.2017
(51) Int. Cl.: H01L 29/78, H01L 29/08, H01L 29/10, H01L 29/12, H01L 29/423, H01L 21/336

(54) **SILICON CARBIDE SWITCH DEVICE AND MANUFACTURING METHOD THEREFOR**
SILICIUMCARBID-SCHALTVORRICHTUNG UND HERSTELLUNGSVERFAHREN DAFÜR
DISPOSITIF DE COMMUTATION AU CARBURE DE SILICIUM ET SON PROCÉDÉ DE FABRICATION

(30) Priority: 24.07.2017 CN 201710605642
(43) Date of publication of application: 15.04.2020
(73) Proprietor: China Electronics Technology Group Corporation No.55 Research Institute, Nanjing, Jiangsu 210016 (CN)
(72) Inventor: HUANG, Runhua, Nanjing Jiangsu 210016 (CN); BAI, Song, Nanjing Jiangsu 210016 (CN); TAO, Yonghong, Nanjing Jiangsu 210016 (CN); WANG, Ling, Nanjing Jiangsu 210016 (CN); LIU, Ao, Nanjing Jiangsu 210016 (CN); LI, Shiyan, Nanjing Jiangsu 210016 (CN); LIU, Hao, Nanjing Jiangsu 210016 (CN)
(74) Representative: Murgitroyd & Company
(86) International application number: PCT/CN2017/104856
(87) International publication number: WO 2019/019395

(56) References cited:
- CN-A- 104 319 292
- CN-A- 104 979 395
- CN-A- 106 847 879
- CN-A- 106 847 879
- US-A- 5 907 169
- US-A1- 2002 139 992
- US-A1- 2014 284 656
- US-A1- 2016 225 905

## Description

### TECHNICAL FIELD

The present invention belongs to the field of semiconductor device technologies, and more particularly, relates to a Silicon Carbide, SiC, switch device and a manufacturing method thereof.

### BACKGROUND

SiC materials have excellent performances like a large band gap, a high breakdown electric field, a high saturated drift velocity and a large thermal conductivity, which enable these materials to become ideal materials for manufacturing a device with a high power, a high frequency, a high temperature resistance and a radiation resistance. A SiC Schottky diode has a series of advantages such as a high breakdown voltage, a high current density, a high working frequency, etc., thus having a very wide development prospect.

At present, a SiC MOSFET device has a low channel mobility due to the limitation of an oxidation level, thus causing an excessively large ratio of a channel resistance to an overall on-resistance. In order to achieve a better conduction capability, a short channel is usually used in the SiC MOSFET device, while the short channel will usually reduce a preset voltage of the device; and meanwhile, a blocking performance of the device is reduced, and a redundancy of the device to channel length fluctuation is decreased, which affects a productivity of the device. In addition, technologies for oxidizing the SiC are developed slowly due to different material properties of the SiC, and the channel resistance is a major factor that hinders the performances of the device for a long time. Therefore, it is necessary to develop a new SiC MOSFET structure to reduce a ratio of the channel resistance.

Reference is made to the documents US2016/225905, US5907169, US2014/284656 and CN 106847879 which disclose SiC MOSFET devices with raised mesa structures at whose sidewall at least a portion of the channel region is formed.

### SUMMARY

It will be appreciated that the scope of the invention is in accordance with the claims. Accordingly, there is provided an arrangement in accordance with the independent claims. Further features are provided in accordance with the dependent claims.

Object of the invention: aiming at the problems above, the present invention provides a SiC switch device and a manufacturing method thereof, for use to reduce a ratio of a channel resistance to a device on-resistance.

The present specification provides arrangements including the following: a SiC switch device includes a substrate, wherein a drift layer of a first conduction type, a doped P_{well} region of a second conduction type formed by ion implantation, an N+ region of a first conduction type formed by ion implantation and a doped P+ region of a second conduction type formed by ion implantation are arranged above the substrate. A first epitaxial region of a first conduction type and a second epitaxial N+ region are sequentially arranged above the drift layer of the first conduction type; a lateral implantation P_{well} region of a second conduction type is formed by lateral ion implantation on a surface of the device; an oxide gate dielectric layer is arranged above the lateral implantation P_{well} region; a gate electrode is arranged above the gate dielectric layer; an isolation dielectric is arranged above the gate electrode; and an ohmic contact drain electrode is arranged below the substrate, and an ohmic contact region is arranged on one side of the lateral implantation P_{well} region above the device.

A method for manufacturing a SiC switch device includes the following steps of:
(1) epitaxially growing a drift layer of a first conduction type on a substrate of a first conduction type;
(2) forming a doped P_{well} region of a second conduction type on the drift layer by ion implantation;
(3) forming an N+ region of a first conduction type on the doped P_{well} region by ion implantation;
(4) forming a doped P+ region of a second conduction type on the doped P_{well} region by ion implantation, wherein the P+ region is connected with both the N+ region and the doped P_{well} region;
(5) forming a first epitaxial region of a first conduction type and a second epitaxial N+ region in an epitaxial growth sequence on a surface of the device;
(6) forming a SiC step on the first epitaxial region and the second epitaxial N+ region by an etching process;
(7) forming a lateral implantation P_{well} region of a second conduction type on the surface of the device by lateral ion implantation;
(8) forming an oxide gate dielectric layer on the lateral implantation P_{well} region by high-temperature oxidation;
(9) manufacturing a gate electrode on one side of the surface of the device by growth;
(10) growing an isolation dielectric on the surface of the device;
(11) opening a dielectric hole in the isolation dielectric and the gate dielectric layer by etching; and
(12) manufacturing an ohmic contact drain electrode on a back surface of the substrate by a metallization process, and forming an ohmic contact region on one side of the lateral implantation P_{well} region on an upper surface of the device by high-temperature annealing.

Beneficial effects: the arrangements of the present specification and claims can effectively reduce the ratio of the channel resistance to the device on-resistance, and achieves on-off of the device using two mechanisms. The channel on the sidewall of the first epitaxial region is very short, and an epitaxial drift layer current path can be turned off as long as a high enough voltage drop is generated in a turn-off process, without considering channel punch-through under a high voltage. Therefore, the present invention has great advantages in comparison with the prior art. Meanwhile, under the condition that a wide epitaxial drift layer current path is used in the device, a preset voltage is maintained to be positive, so that the present invention has great advantages in comparison with a traditional SiC JFET.

### BRIEF DESCRIPTION OF THE DRAWINGS

Fig. 1 is a schematic diagram illustrating epitaxial growth;
Fig. 2 is a schematic diagram illustrating implantation of a P_{well} region;
Fig. 3 is a schematic diagram illustrating implantation of an N+ region;
Fig. 4 is a schematic diagram illustrating implantation of a P+ region;
Fig. 5 is a schematic diagram illustrating epitaxial growth;
Fig. 6 is a schematic diagram illustrating etching of an epitaxial layer;
Fig. 7 is a schematic diagram illustrating lateral ion implantation of a MOS channel region;
Fig. 8 is a schematic diagram illustrating growth of a gate dielectric;
Fig. 9 is a schematic diagram illustrating manufacturing of a gate electrode;
Fig. 10 is a schematic diagram illustrating growth of an isolation dielectric;
Fig. 11 is a schematic diagram illustrating etching of a dielectric hole; and
Fig. 12 is a schematic diagram illustrating metallization of an ohmic contact.

### DETAILED DESCRIPTION

The technical solutions of the invention are further described hereinafter with reference to the drawings and the embodiments.

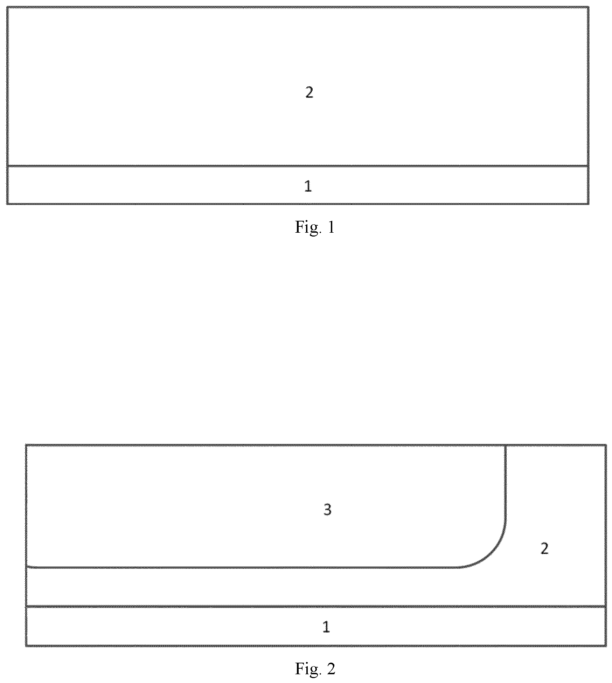

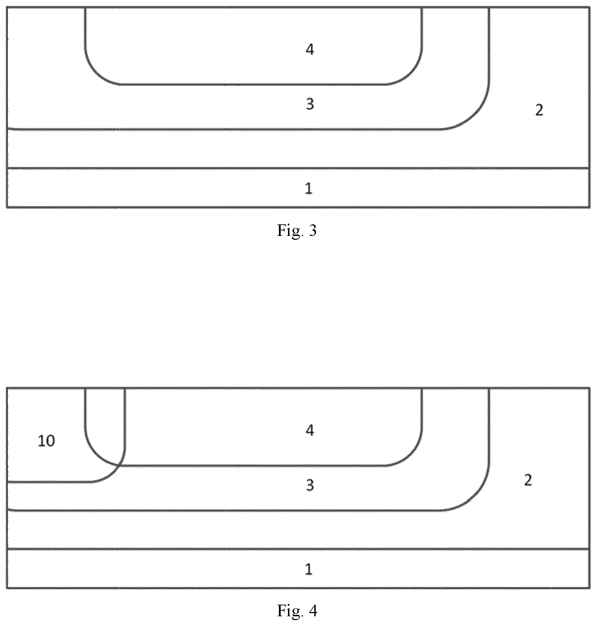

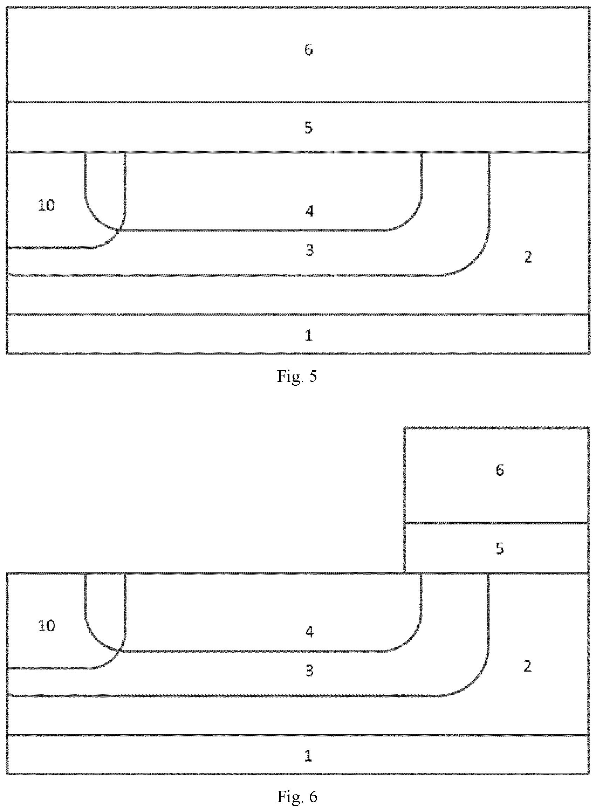

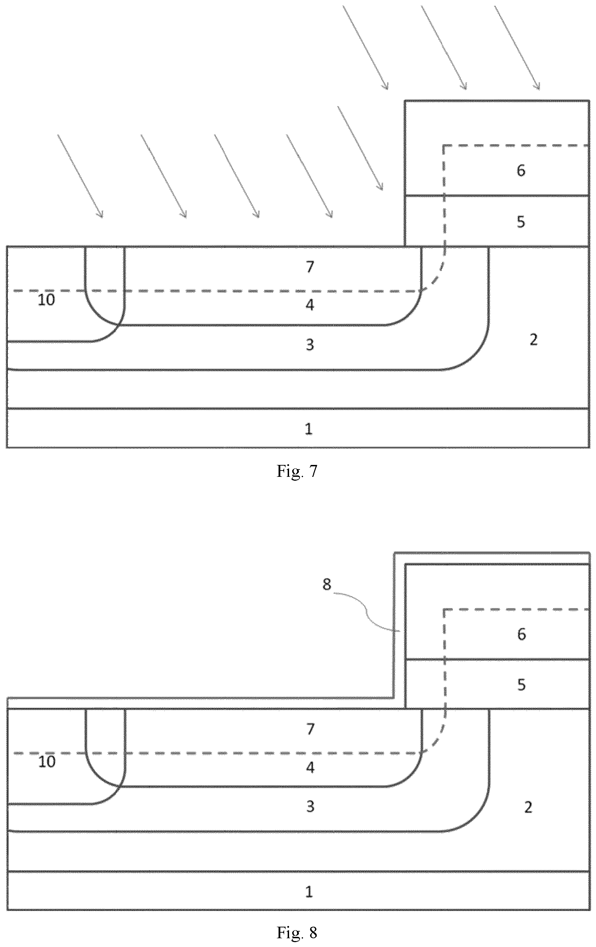

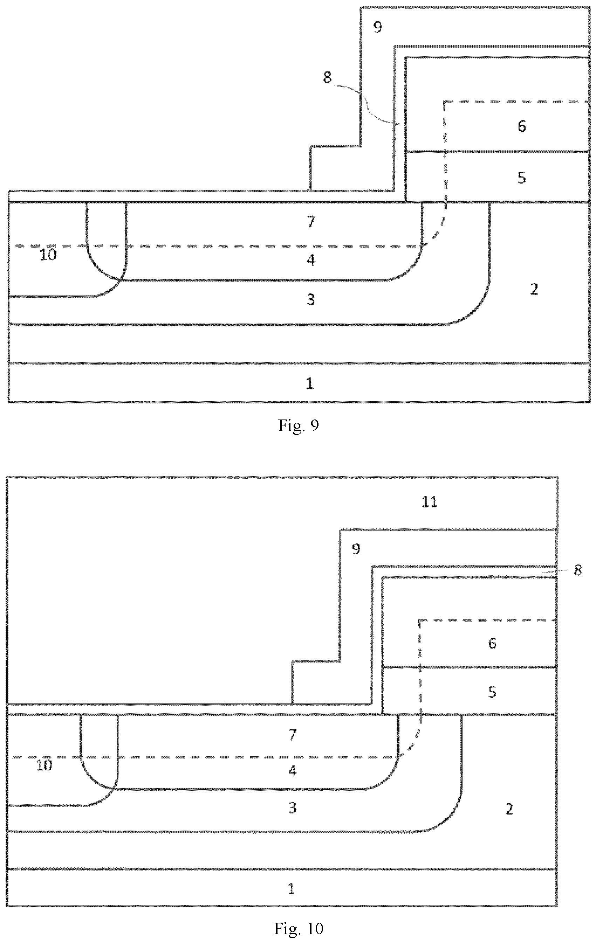

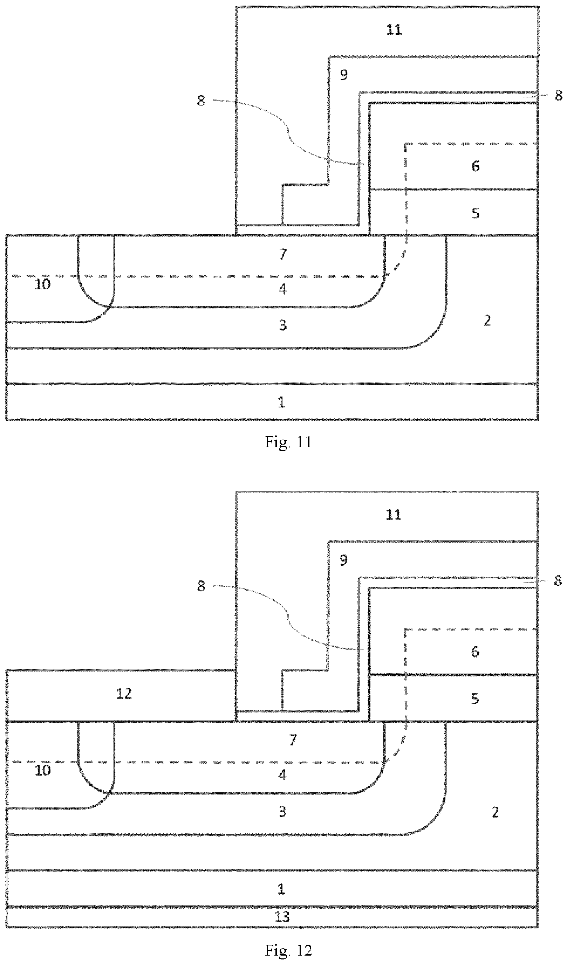

The invention discloses a SiC switch device and a manufacturing method thereof, wherein the method includes the following steps.
(1) As shown in Fig. 1, a drift layer 2 of a first conduction type epitaxially grows on a substrate 1 of a first conduction type.
   The substrate 1 of the first conduction type is a SiC or silicon crystal, such as 4H, 6H and 3C crystal structures, with a doping concentration more than 1E19 cm⁻³.
(2) As shown in Fig. 2, a doped P_{well} region 3 of a second conduction type is formed on the drift layer 2 by ion implantation.
   The drift layer 2 is a SiC thin film, such as 4H, 6H and 3C crystal structures, with a doping concentration ranging from 1E14 cm⁻³ to 1.5E16 cm⁻³. When the first conduction type is N-type doping, a doped impurity is a nitrogen atom, and when the first conduction type is P-type doping, the doped impurity is aluminum.
(3) As shown in Fig. 3, an N+ region 4 of a first conduction type is formed on the doped P_{well} region 3 by ion implantation.
(4) As shown in Fig. 4, a doped P+ region 10 of a second conduction type is formed on the doped P_{well} region 3 by ion implantation, wherein the P+ region 10 is connected with both the N+ region 4 and the doped P_{well} region 3.
(5) As shown in Fig. 5, a first epitaxial region 5 of a first conduction type and a second epitaxial N+ region 6 are formed in an epitaxial growth sequence on a surface of the device.
   A thickness of the first epitaxial region 5 is smaller than 2 µm. A top structure of the device is processed by two times of epitaxial growth of the first epitaxial region 5 and the second epitaxial N+ region 6, wherein a doping concentration of the first epitaxial region 5 is lower than that of a lateral implantation P_{well} region 7, a doping concentration of the second epitaxial N+ region 6 is far higher than that of the lateral implantation P_{well} region 7, a doping concentration of the N+ region 4 is far higher than that of the lateral implantation P_{well} region 7, and the doping concentration of the first epitaxial region 5 is higher than that of the drift layer 2. Such a structure makes a length of a channel on a sidewall of the first epitaxial region 5 depend on an epitaxial growth thickness.
(6) As shown in Fig. 6, a SiC step is formed by an etching process.
(7) As shown in Fig. 7, a lateral implantation P_{well} region 7 of a second conduction type is formed on the surface of the device by lateral ion implantation.
   Lateral ion implantation is used in the lateral implantation P_{well} region 7, and an included angle between an implantation direction and a wafer surface ranges from 85 degrees to 0 degree. The method can form the channel on the sidewall and ensures that the doped region of the second type on the sidewall has a sufficient width.
(8) As shown in Fig. 8, an oxide gate dielectric layer 8 is formed on the lateral implantation P_{well} region 7 by high-temperature oxidation. A growth thickness of the gate dielectric layer ranges from 0.005 µm to 1 µm.
(9) As shown in Fig. 9, a gate electrode 9 is manufactured on the gate dielectric layer 8 by growth.
(10) As shown in Fig. 10, an isolation dielectric 11 grows on the surface of the device.
(11) As shown in Fig. 11, a dielectric hole is opened by etching.
(12) As shown in Fig. 12, an ohmic contact drain electrode 13 is manufactured on a back surface of the substrate 1 by a metallization process, and an ohmic contact region 12 is formed on one side of the lateral implantation P_{well} region 7 on an upper surface of the device by high-temperature annealing.

When the gate electrode 9 is applied with a forward voltage, a conductive channel is inversely formed on a surface of a sidewall of a semiconductor in a part of the first epitaxial region 5 intersected with the lateral implantation P_{well} region 7, and the switch device is turned on. When the voltage applied to the gate electrode 9 is gradually decreased, the channel resistance is increased rapidly, which further causes a higher voltage drop in a channel where the current passes through. Since the N+ region 4, the P+ region 10 and the doped P_{well} region 3 are connected, and potentials of the three regions are the same, the generated voltage drop will cause a potential of the epitaxial drift layer 2 to be higher than that of the doped P_{well} region 3, thus increasing a width of a depletion region of the doped P_{well} region 3 in the epitaxial drift layer 2. With gradual decrease of the voltage, the depletion region of the doped P_{well} region 3 in the epitaxial drift layer 2 becomes larger and larger, and finally a current path in the epitaxial drift layer 2 is completely turned off.

The on-off of the device is achieved using the two mechanisms above. The channel on the sidewall of the first epitaxial region 5 may be very short, and the epitaxial drift layer 2 current path can be turned off as long as a high enough voltage drop is generated in a turn-off process, without considering channel punch-through under a high voltage. Therefore, the present invention has great advantages in comparison with the prior art. Meanwhile, a wide epitaxial drift layer 2 current path may be used, and a preset voltage is maintained to be positive, so that the present invention has great advantages in comparison with a traditional SiC JFET. The device is a device normally turned off.

## Claims

1. A method for manufacturing a Silicon Carbide, SiC, switch device, comprising the following steps of:
(1) epitaxially growing a drift layer (2) of a first conduction type on the front side of a substrate (1) of a first conduction type;
(2) forming a doped P_{well} region (3) of a second conduction type on the drift layer (2) by ion implantation;
(3) forming an N+ region (4) of a first conduction type on the doped P_{well} region by ion implantation;
(4) forming a doped P+ region (10) of a second conduction type on the doped P_{well} region by ion implantation, wherein the P+ region is connected with both the N+ region and the doped P_{well} region;
(5) forming a first epitaxial region (5) of a first conduction type and a second epitaxial N+ region (6) in an epitaxial growth sequence on a surface of the device;
(6) etching the first epitaxial region (5) and the second epitaxial N+ region (6) to form a SiC step, leaving the N+ region (4) partially and the doped P+ region (10) completely exposed;
(7) forming a lateral implantation P_{well} region (7) of a second conduction type on the surface of the device by lateral ion implantation;
(8) forming an oxide gate dielectric layer (8) on the lateral implantation P_{well} region (7) by high-temperature oxidation;
(9) manufacturing a gate electrode (9) on one side of the surface of the device by growth;
(10) growing an isolation dielectric (11) on the surface of the device;
(11) opening a dielectric hole in the isolation dielectric (11) and the gate dielectric layer (8) by etching; and
(12) manufacturing an ohmic contact drain electrode (13) on a back surface of the substrate by a metallization process, and forming an ohmic contact region (12) on one side of the lateral implantation P_{well} region (7) on an upper surface of the device by high-temperature annealing;
wherein a doping concentration of the second epitaxial N+ region (6) is higher than that of the implantation P_{well} region (7) and a doping concentration of the implantation N+ region (4) is higher than that of the implantation P_{well} region (7).

2. The method for manufacturing the SiC switch device according to claim 1, wherein, in step (7), an angle between an implantation direction and the surface defined by the exposed portion of the N+ region (4) and the exposed doped P+ region (10) ranges from 85 degrees to 0 degree.

3. The method for manufacturing the SiC switch device according to claims 1 or 2 wherein step (6) exposes the P + region and the N + region on the substrate surface to form a sidewall channel on the sidewall of the first epitaxial region (5).

4. A Silicon Carbide, SiC, switch device, comprising:
a substrate (1),
a drift layer (2) of a first conduction type above the substrate (1),
a doped implantation P_{well} region (3) of a second conduction type within the drift layer (2),
an implantation N+ region (4) of a first conduction type and a doped implantation P+ region (10) of a second conduction type within the doped implantation P_{well} region (3);
a first epitaxial region (5) of a first conduction type and a second epitaxial N+ region (6) being sequentially arranged above the drift layer (2) of the first conduction type and forming a SiC step leaving the N+ region (4) partially and the doped P+ region (10) completely exposed; and
an implantation P_{well} region (7) of a second conduction type forming a sidewall channel of a second conduction type in the first region (5) and being in contact with the implantation N+ region (4) and with the doped implantation P_{well} region (3) ;
an oxide gate dielectric layer (8) arranged above the implantation P_{well} region (7);
a gate electrode (9) arranged above the gate dielectric layer (8);
an isolation dielectric (11) arranged above the gate electrode (9);
an ohmic contact drain electrode (13) arranged below the substrate (1) and an ohmic contact region (12) arranged on one side of the implantation P_{well} region (7) above the implantation N+ region (4) and the doped implantation P+ region (10) of the device;
wherein a doping concentration of the second epitaxial N+ region (6) is higher than that of the implantation P_{well} region (7), and a doping concentration of the implantation N+ region (4) is higher than that of the implantation P_{well} region (7).

5. The SiC switch device according to claim 4, wherein an implantation depth of the doped P_{well} region (3) of the second conduction type is smaller than that of the drift layer (2) of the first conduction type, and an implantation depth of the N+ region (4) of the first conduction type is smaller than an implantation depth of the doped P+ region (10) of the second conduction type.

6. The SiC switch device according to claim 4, wherein a doping concentration of the lateral implantation P_{well} region (7) is higher than that of the first epitaxial region (5).

7. The SiC switch device according to claim 4, wherein a doping concentration of the first epitaxial region (5) is higher than that of the drift layer (2).

8. The SiC switch device according to claim 4, wherein a thickness of the first epitaxial region (5) is smaller than 2 µm.

9. The SiC switch device according to claim 4, wherein a growth thickness of the gate dielectric layer (8) ranges from 0.005 µm to 1 µm.

## Patentansprüche

1. Ein Verfahren zum Herstellen einer Siliciumcarbidschaltvorrichtung, SiC-Schaltvorrichtung, das die folgenden Schritte beinhaltet:
(1) epitaktisches Aufwachsen einer Driftschicht (2) eines ersten Leitungstyps auf der Vorderseite eines Substrats (1) eines ersten Leitungstyps;
(2) Bilden einer dotierten P_{Wanne}-Region (3) eines zweiten Leitungstyps auf der Driftschicht (2) durch lonenimplantation;
(3) Bilden einer N+-Region (4) eines ersten Leitungstyps auf der dotierten Pwanne-Region durch lonenimplantation;
(4) Bilden einer dotierten P+-Region (10) eines zweiten Leitungstyps auf der dotierten P_{Wanne}-Region durch Ionenimplantation, wobei die P+-Region sowohl mit der N+-Region als auch der dotierten Pwanne-Region verbunden ist;
(5) Bilden einer ersten epitaktischen Region (5) eines ersten Leitungstyps und einer zweiten epitaktischen N+-Region (6) in einer epitaktischen Aufwachsreihenfolge auf einer Oberfläche der Vorrichtung;
(6) Ätzen der ersten epitaktischen Region (5) und der zweiten epitaktischen N+-Region (6), um eine SiC-Stufe zu bilden, was die N+-Region (4) teilweise und die dotierte P+-Region (10) ganz frei lässt;
(7) Bilden einer seitlich implantierten Pwanne-Region (7) eines zweiten Leitungstyps auf der Oberfläche der Vorrichtung durch seitliche Ionenimplantation;
(8) Bilden einer Oxidgatter-Dielektrikumsschicht (8) auf der seitlich implantierten P_{Wanne}-Region (7) durch Hochtemperaturoxidation;
(9) Herstellen einer Gatterelektrode (9) auf einer Seite der Oberfläche der Vorrichtung durch Aufwachsen;
(10) Aufwachsen eines Isolationsdielektrikums (11) auf der Oberfläche der Vorrichtung;
(11) Öffnen eines dielektrischen Lochs in dem Isolationsdielektrikum (11) und der Gatter-Dielektrikumsschicht (8) durch Ätzen; und
(12) Herstellen einer Senkenelektrode (13) mit ohmschem Kontakt auf einer Rückseite des Substrats durch einen Metallisierungsvorgang und Bilden einer ohmschen Kontaktregion (12) auf einer Seite der seitlich implantierten Pwanne-Region (7) auf einer Oberfläche der Vorrichtung durch Hochtemperaturtempern;
wobei eine Dotierungskonzentration der zweiten epitaktischen N+-Region (6) höher als die der implantierten P_{Wanne}-Region (7) ist und eine Dotierungskonzentration der implantierten N+-Region (4) höher als die der implantierten Pwanne-Region (7) ist.

2. Verfahren zum Herstellen der SiC-Schaltvorrichtung gemäß Anspruch 1, wobei in Schritt (7) ein Winkel zwischen einer Implantationsrichtung und der durch den freien Abschnitt der N+-Region (4) und die freie dotierte P+-Region (10) definierten Oberfläche von 85 Grad bis 0 Grad reicht.

3. Verfahren zum Herstellen der SiC-Schaltvorrichtung gemäß Anspruch 1 oder 2, wobei Schritt (6) die P+-Region und die N+-Region auf der Substratoberfläche freilegt, um einen Seitenwandkanal an der Seitenwand der ersten epitaktischen Region (5) zu bilden.

4. Eine Siliciumcarbidschaltvorrichtung, SiC-Schaltvorrichtung, die Folgendes beinhaltet:
ein Substrat (1),
eine Driftschicht (2) eines ersten Leitungstyps über dem Substrat (1),
eine dotierte implantierte P_{Wanne}-Region (3) eines zweiten Leitungstyps innerhalb der Driftschicht (2),
eine implantierte N+-Region (4) eines ersten Leitungstyps und eine dotierte implantierte P+-Region (10) eines zweiten Leitungstyps innerhalb der dotierten implantierten P_{Wanne}-Region (3);
eine erste epitaktische Region (5) eines ersten Leitungstyps und eine zweite epitaktische N+-Region (6), die der Reihe nach über der Driftschicht (2) des ersten Leitungstyps angeordnet sind und eine SiC-Stufe bilden, was die N+-Region (4) teilweise und die dotierte P+-Region (10) ganz frei lässt; und
eine implantierte P_{Wanne}-Region (7) eines zweiten Leitungstyps, die einen Seitenwandkanal eines zweiten Leitungstyps in der ersten Region (5) bildet und in Kontakt mit der implantierten N+-Region (4) und mit der dotierten implantierten Pwanne-Region (3) steht;
eine Oxidgatter-Dielektrikumsschicht (8), die über der implantierten P_{Wanne}-Region (7) angeordnet ist;
eine Gatterelektrode (9), die über der Gatter-Dielektrikumsschicht (8) angeordnet ist;
ein Isolationsdielektrikum (11), das über der Gatterelektrode (9) angeordnet ist;
eine Senkenelektrode (13) mit ohmschem Kontakt, die unter dem Substrat (1) und einer ohmschen Kontaktregion (12), die auf einer Seite der implantierten Pwanne-Region (7) über der implantierten N+-Region (4) und der dotierten implantierten P+-Region (10) der Vorrichtung angeordnet ist, angeordnet ist;
wobei eine Dotierungskonzentration der zweiten epitaktischen N+-Region (6) höher als die der implantierten P_{Wanne}-Region (7) ist und eine Dotierungskonzentration der implantierten N+-Region (4) höher als die der implantierten Pwanne-Region (7) ist.

5. SiC-Schaltvorrichtung gemäß Anspruch 4, wobei eine Implantationstiefe der dotierten P_{Wanne}-Region (3) des zweiten Leitungstyps geringer als die der Driftschicht (2) des ersten Leitungstyps ist,
und eine Implantationstiefe der N+-Region (4) des ersten Leitungstyps geringer als eine Implantationstiefe der dotierten P+-Region (10) des zweiten Leitungstyps ist.

6. SiC-Schaltvorrichtung gemäß Anspruch 4, wobei eine Dotierungskonzentration der seitlich implantierten P_{Wanne}-Region (7) höher als die der ersten epitaktischen Region (5) ist.

7. SiC-Schaltvorrichtung gemäß Anspruch 4, wobei eine Dotierungskonzentration der ersten epitaktischen Region (5) höher als die der Driftschicht (2) ist.

8. SiC-Schaltvorrichtung gemäß Anspruch 4, wobei eine Dicke der ersten epitaktischen Region (5) geringer als 2 µm ist.

9. SiC-Schaltvorrichtung gemäß Anspruch 4, wobei eine Aufwachsdicke der Gatter-Dielektrikumsschicht (8) von 0,005 µm bis 1 µm reicht.

## Revendications

1. Un procédé pour la fabrication d'un dispositif de commutation au carbure de silicium, SiC, comprenant les étapes suivantes :
(1) croissance épitaxiale d'une couche de dérive (2) d'un premier type de conduction sur le côté avant d'un substrat (1) d'un premier type de conduction ;
(2) formation d'une région P_{well} dopée (3) d'un deuxième type de conduction sur la couche de dérive (2) par implantation ionique ;
(3) formation d'une région N+ (4) d'un premier type de conduction sur la région P_{well} dopée par implantation ionique ;
(4) formation d'une région P+ dopée (10) d'un deuxième type de conduction sur la région P_{well} dopée par implantation ionique, la région P+ étant reliée aussi bien à la région N+ qu'à la région P_{well} dopée ;
(5) formation d'une première région épitaxiale (5) d'un premier type de conduction et d'une deuxième région N+ épitaxiale (6) dans une séquence de croissance épitaxiale sur une surface du dispositif ;
(6) gravure de la première région épitaxiale (5) et de la deuxième région N+ épitaxiale (6) pour former une marche de SiC, laissant la région N+ (4) partiellement exposée et la région P+ dopée (10) complètement exposée ;
(7) formation d'une région P_{well} d'implantation latérale (7) d'un deuxième type de conduction sur la surface du dispositif par implantation ionique latérale ;
(8) formation d'une couche de diélectrique de grille en oxyde (8) sur la région P_{well} d'implantation latérale (7) par oxydation à haute température ;
(9) fabrication d'une électrode de grille (9) sur un côté de la surface du dispositif par croissance ;
(10) croissance d'un diélectrique d'isolation (11) sur la surface du dispositif ;
(11) ouverture d'un trou de diélectrique dans le diélectrique d'isolation (11) et la couche de diélectrique de grille (8) par gravure ; et
(12) fabrication d'une électrode de drain de contact ohmique (13) sur une surface arrière du substrat par un processus de métallisation, et formation d'une région de contact ohmique (12) sur un côté de la région P_{well} d'implantation latérale (7) sur une surface supérieure du dispositif par recuit à haute température ;
dans lequel une concentration de dopage de la deuxième région N+ épitaxiale (6) est plus élevée que celle de la région P_{well} d'implantation (7) et une concentration de dopage de la région N+ d'implantation (4) est plus élevée que celle de la région P_{well} d'implantation (7).

2. Le procédé pour la fabrication du dispositif de commutation au SiC selon la revendication 1, dans lequel, à l'étape (7), un angle entre une direction d'implantation et la surface définie par la portion exposée de la région N+ (4) et la région P+ dopée (10) exposée va de 85 degrés à 0 degré.

3. Le procédé pour la fabrication du dispositif de commutation au SiC selon les revendications 1 ou 2 dans lequel l'étape (6) expose la région P+ et la région N+ sur la surface du substrat pour former un canal de flanc sur le flanc de la première région épitaxiale (5).

4. Un dispositif de commutation au carbure de silicium, SiC, comprenant :
un substrat (1),
une couche de dérive (2) d'un premier type de conduction au-dessus du substrat (1),
une région P_{well} d'implantation dopée (3) d'un deuxième type de conduction à l'intérieur de la couche de dérive (2),
une région N+ d'implantation (4) d'un premier type de conduction et une région P+ d'implantation dopée (10) d'un deuxième type de conduction à l'intérieur de la région P_{well} d'implantation dopée (3) ;
une première région épitaxiale (5) d'un premier type de conduction et une deuxième région N+ épitaxiale (6) qui sont agencées séquentiellement au-dessus de la couche de dérive (2) du premier type de conduction et forment une marche de SiC laissant la région N+ (4) partiellement exposée et la région P+ dopée (10) complètement exposée ; et
une région P_{well} d'implantation (7) d'un deuxième type de conduction formant un canal de flanc d'un deuxième type de conduction dans la première région (5) et étant en contact avec la région N+ d'implantation (4) et avec la région P_{well} d'implantation dopée (3) ;
une couche de diélectrique de grille en oxyde (8) agencée au-dessus de la région P_{well} d'implantation (7) ;
une électrode de grille (9) agencée au-dessus de la couche de diélectrique de grille (8) ;
un diélectrique d'isolation (11) agencé au-dessus de l'électrode de grille (9) ;
une électrode de drain de contact ohmique (13) agencée au-dessous du substrat (1) et
une région de contact ohmique (12) agencée sur un côté de la région P_{well} d'implantation (7) au-dessus de la région N+ d'implantation (4) et de la région P+ d'implantation dopée (10) du dispositif ;
dans lequel une concentration de dopage de la deuxième région N+ épitaxiale (6) est plus élevée que celle de la région P_{well} d'implantation (7), et une concentration de dopage de la région N+ d'implantation (4) est plus élevée que celle de la région P_{well} d'implantation (7).

5. Le dispositif de commutation au SiC selon la revendication 4, dans lequel une profondeur d'implantation de la région P_{well} dopée (3) du deuxième type de conduction est plus petite que celle de la couche de dérive (2) du premier type de conduction, et une profondeur d'implantation de la région N+ (4) du premier type de conduction est plus petite qu'une profondeur d'implantation de la région P+ dopée (10) du deuxième type de conduction.

6. Le dispositif de commutation au SiC selon la revendication 4, dans lequel une concentration de dopage de la région P_{well} d'implantation latérale (7) est plus élevée que celle de la première région épitaxiale (5).

7. Le dispositif de commutation au SiC selon la revendication 4, dans lequel une concentration de dopage de la première région épitaxiale (5) est plus élevée que celle de la couche de dérive (2).

8. Le dispositif de commutation au SiC selon la revendication 4, dans lequel une épaisseur de la première région épitaxiale (5) est plus petite que 2 µm.

9. Le dispositif de commutation au SiC selon la revendication 4, dans lequel une épaisseur de croissance de la couche de diélectrique de grille (8) va de 0,005 µm à 1 µm.
